# FASCICULE DE BREVET EUROPEEN

(11) **EP 0 634 378 B1**
(45) Date de publication et mention de la délivrance du brevet: **02.04.1997**
(21) Numéro de dépôt: 94401563.5
(22) Date de dépôt: 07.07.1994
(51) Int. Cl.: C04B 35/80, C03C 14/00, C23C 16/30

(54) **Procédé pour améliorer la tenue à l'oxydation d'un matériau composite à renfort fibreux et à matrice verre, vitrocéramique ou céramique**
Verfahren zur Verbesserung de Oxidationsbeständigkeit von faserverstärkten Verbundstoffen mit einer Glas-, Keramik- oder Glaskeramikmatrix
Process for improving the oxydation resistance of a fibre-reinforced composite having a glass, ceramic or glass-ceramic matrix

(30) Priorité: 12.07.1993 FR 9308551
(43) Date de publication de la demande: 18.01.1995
(73) Titulaire: AEROSPATIALE SOCIETE NATIONALE INDUSTRIELLE, 75016 Paris (FR)
(72) Inventeur: Larnac, Guy, F-33160 St. Medard en Jalles (FR); Saugnac, Frédéric Résidence le Mandarin B2, F-31400 Toulouse (FR)
(74) Mandataire: Lepeudry-Gautherat, Thérèse

(56) Documents cités:
- EP-A- 0 095 433
- EP-A- 0 517 463
- DE-A- 3 933 039
- CHEMICAL ABSTRACTS, vol. 117, no. 4, 27 Juillet 1992, Columbus, Ohio, US; abstract no. 32270p, H.SCHACHNER ET AL. 'CVD OF ALUMINIUM NITRIDE ON WHISKER SUBSTRATES' page 372 ;

## Description

L'invention concerne l'amélioration de la tenue à l'oxydation des matériaux composites à renfort en fibre céramique ou de carbone, et à matrice de type verre, vitrocéramique ou céramique.

Elle a pour objet un procédé de traitement d'une fibre de renfort de type céramique non-oxyde ou de carbone qui peut être utilisée dans la fabrication d'un matériau composite à matrice verre, vitrocéramique ou céramique présentant une bonne tenue à l'oxydation jusqu'à des températures voisines de 1200°C, pendant une durée prolongée.

Les composites à renfort en fibre céramique ou de carbone et à matrice verre, vitrocéramique ou céramique sont des candidats de choix pour des applications thermostructurales, par exemple à des températures intermédiaires de 500°C pour les composites à matrice verre et jusqu'à 1200°C pour les composites à matrice vitrocéramique. Le développement de ces matériaux composites s'est accéléré ces dernières années du fait de leurs applications potentielles de plus en plus nombreuses, notamment dans les domaines aéronautiques et spatiaux.

Des exemples de réalisation de tels composites sont donnés, par exemple, dans l'article de J. J. Brennan et K. M. Prewo, J. Mat. Science 17 (1982) pages 2371-2383, ainsi que dans le brevet US 4 341 826.

La fibre de carbure de silicium, SiC, fabriquée par NIPPON CARBON Co et utilisée comme renfort dans ces composites, développe lorsqu'elle est portée au-dessus de 1000°C, sous atmosphère inerte, une couche de carbone superficielle. Lors de la fabrication des composites tels que décrits dans l'art antérieur, cette couche de carbone se forme à l'interface entre la fibre et la matrice. Les mécanismes de sa formation sont notamment décrits dans l'article de R. F. Cooper et K. Chyung, J. Mat. Science, 22, (1987), pages 3148-3160. Cette couche de carbone procure au composite une faible valeur de la contrainte de cisaillement interfaciale. Il en résulte que le composite présente, lorsqu'il est sollicité mécaniquement jusqu'à sa rupture dans un milieu non oxydant, un comportement de type non fragile. La formation de carbone interfacial est particulière à la fibre de SiC utilisée qui est commercialisée sous la dénomination Nicalon®. Elle ne se produit par exemple pas avec la fibre de SiCN commercialisée par DOW-CORNING sous la référence HPZ, ainsi que cela est rapporté par J. J. Brennan, dans son article : Glass and Glass-Ceramic Matrix Composites, pages 222-259 de l'ouvrage de K. S. Mazdiyasni, "FIBER REINFORCED CERAMIC COMPOSITES", Materials, Processing and Technology, Noyes publications, 1990. Dans ce cas, la contrainte de cisaillement interfaciale est très élevée et la rupture se produit de façon fragile.

Différentes méthodes visant à ajuster les valeurs des contraintes de cisaillement interfaciales ont été développées. Ainsi le brevet US 4 485 179 décrit, par exemple, l'ajout de Nb₂O₅ ou Ta₂O₅ à la composition matricielle. Ces oxydes réagissent avec le carbone de la fibre et se transforment en carbures théoriquement plus résistants à l'oxydation que le carbone. Une autre technique consiste à déposer sur la fibre, avant l'élaboration du composite, une couche de carbone pyrolytique ou de nitrure de bore (BN), comme décrit dans les brevets FR 2 567 874 et US 4 605 588. Cette technique peut s'appliquer à des fibres autres que la fibre de SiC Nicalon®. La faible contrainte de cisaillement interfaciale provient de la possibilité de glissement des plans cristallins des dépôts de graphite ou de BN. L'efficacité de ces dépôts est cependant limitée puisque le graphite s'oxyde sous air dès 550°C. Le BN, quant à lui, s'oxyde dès 800°C. L'anhydride borique, B₂O₃, qui est ainsi formé peut provoquer, du fait de sa température de fusion peu élevée, un fluage important au niveau de l'interface.

La demande de brevet EP 0 366 234 décrit un procédé de revêtement de fibres par un dépôt de silicate bidimensionnel possédant une structure cristalline en feuillet de type mica. Cette méthode donne lieu à des comportements à la rupture non fragiles des composites élaborés avec cette fibre. Cependant, il apparaît que de telles compositions de silicate possèdent des éléments tels que lithium ou sodium qui sont connus pour migrer vers l'intérieur des fibres de type Nicalon® et altérer leurs propriétés mécaniques. Un autre inconvénient provient du fait qu'il soit nécessaire de contrôler la cristallisation du dépôt afin que celui-ci se trouve dans la forme cristalline voulue pour assurer le clivage des plans cristallins. Cet inconvénient rend complexe la réalisation de tels composites.

On a déjà proposé des solutions tendant à remédier aux inconvénients de l'art antérieur exposé ci-dessus.

La demande de brevet FR 2 673 939 propose, pour rendre tenace un composite céramique constitué de fibres céramiques "non oxydiques" immergées dans une matrice céramique, de traiter les fibres, avant la fabrication du composite, par une solution organométallique, évaporer le solvant et oxyder les composés organiques résiduels de manière à obtenir sur les fibres un revêtement ductile ou souple de métal noble pur qui atténue les fissures en cours d'évolution dans la matrice.

Cette technique utilise un revêtement coûteux et nécessite plusieurs étapes.

La demande de brevet FR 2 673 937 propose de munir les fibres de renfort d'un revêtement céramique multicouche entourant chaque fibre et dans lequel les couches multiples ne sont pas liées ou sont séparables. Ce procédé est également complexe.

La demande de brevet FR 2 673 938 propose de munir les fibres de renfort d'un revêtement poreux dont les pores sont de préférence "maintenus vides" au moyen d'une couche d'obturation non poreuse formée sur le revêtement poreux.

La demande de brevet FR 2 673 940 propose de revêtir les fibres de renfort d'un revêtement pré-fissuré.

Ces quatre demandes de brevet proposent, de façon très générale, des solutions souvent complexes qui ne sont pas étayées par des exemples et qui ne prennent pas en compte le problème de l'adhésion du revêtement sur la fibre.

Le but de l'invention est de mettre au point un procédé permettant de réaliser, de façon simple, à la surface d'une fibre de renfort, préalablement à la mise en forme d'un composite, un dépôt présentant une faible adhérence avec la fibre, de telle sorte que le composite obtenu présente une bonne résistance à l'oxydation jusqu'à des température de 1200°C et pendant des durées prolongées.

Ce but est atteint selon l'invention qui fournit un procédé de traitement des fibres apte à leur conférer les propriétés requises grâce au dépôt d'une couche de nitrure d'aluminium (AlN) dans des conditions particulières.

Plus précisément, l'invention fournit un procédé de traitement d'une fibre de renfort de type céramique nonoxyde ou de carbone qui peut être utilisée dans la fabrication d'un matériau composite à matrice verre, vitrocéramique ou céramique présentant une bonne tenue à l'oxydation jusqu'à des températures voisines de 1200°C, pendant une durée prolongée, caractérisé en ce qu'il comprend essentiellement les étapes successives consistant à :
- si nécessaire, oxyder la fibre en surface ou y déposer une couche de même composition mais comprenant de l'oxygène ;
- introduire la fibre dans une enceinte de dépôt chimique en phase vapeur, dans un arrangement tel que les gaz puissent circuler librement dans l'enceinte ;
- effectuer un prétraitement de la fibre dans l'enceinte à une température choisie dans la gamme de 850 à 1250°C, en présence d'hydrogène, sous une pression de 50 à 300 mbar ;
- injecter dans l'enceinte un mélange de gaz porteur neutre et d'ammoniac dans un rapport en volume de 20 à 60 ;
- arrêter l'injection du mélange et régler la pression dans l'enceinte à une valeur de 1 à 10 mbar ;
- injecter dans l'enceinte du chlorure d'aluminium dans un gaz diluant neutre ;
- effectuer sur la fibre un dépôt de nitrure d'aluminium par injection simultanée dans l'enceinte d'un mélange constitué de chlorure d'aluminium et de gaz porteur neutre, dans un rapport en volume de 0,05 à 0,3, et d'un mélange constitué d'ammoniac et de gaz porteur neutre, dans un rapport en volume de 0,01 à 0,05, les deux mélanges étant utilisés dans un rapport en volume de 0,5 à 2, jusqu'à obtention de l'épaisseur de nitrure d'aluminium souhaitée ;
- stopper l'injection des mélanges gazeux ;
- refroidir l'enceinte sous un courant de gaz neutre ; et
- extraire les fibres ainsi traitées de l'enceinte.

Les fibres qui peuvent être traitées par le procédé de dépôt de nitrure d'aluminium (AlN) selon l'invention sont des fibres de type non-oxyde telles que, par exemple, une fibre de carbure de silicium (SiC), une fibre de carbonitrure de silicium (SiCN) , une fibre de nitrure de silicium (Si₃N₄) ou une fibre de carbone.

Les fibres de SiC et les fibres de SiCN se prêtent particulièrement bien à ce traitement. En tant que fibres de SiC on peut citer la fibre Nicalon® de la société NIPPON CARBON et la fibre Tyranno® de la société UBE, et en tant que fibre de SiCN on peut citer la fibre HPZ de la société DOW-CORNING.

La fibre Nicalon® possède un pourcentage non négligeable de carbone libre et d'oxygène. Selon l'invention, il convient de conserver le carbone et l'oxygène à la surface de la fibre de SiC afin de favoriser une faible adhésion du dépôt d'AlN sur le SiC. Cette faible adhésion procure un comportement non fragile aux composites élaborés avec la fibre ainsi traitée.

Lorsqu'on souhaite traiter une fibre ne possédant normalement pas d'oxygène à sa surface, il convient de l'oxyder ou de la munir d'un dépôt de même composition contenant de l'oxygène.

Ces traitements peuvent être effectués par des techniques classiques, notamment par dépôt chimique en phase vapeur (DCPV), comme pour le dépôt d'AlN.

Le procédé DCPV consiste à mettre au moins un composé volatil, en phase vapeur, en contact avec la surface à recouvrir, de façon à provoquer une réaction chimique donnant au moins un produit solide. La chambre de dépôt est une enceinte réactionnelle ouverte aux deux extrémités, parcourue par un flux gazeux constitué en général d'un gaz vecteur entraînant le ou les gaz précurseur(s) du solide. Cette circulation des gaz se fait le plus souvent sous pression réduite et l'énergie d'activation nécessaire au déclenchement de la réaction se fait par chauffage de la chambre réactionnelle.

Pour que les gaz puissent circuler librement dans l'enceinte de DCPV, la fibre peut être enroulée autour d'un outillage en graphite ajouré.

Les conditions de traitement de la fibre dans l'enceinte de DCPV, en particulier les débits des gaz utilisés, dépendent de la structure et surtout des dimensions de cette enceinte.

Un exemple d'enceinte de DCPV convenant à la mise en oeuvre du procédé selon l'invention est donné dans l'exemple détaillé qui suit, avec les débits de gaz appropriés.

La Demanderesse a démontré que pour obtenir une adhésion adéquate fibre-AlN, il est indispensable de faire subir à la fibre un prétraitement de préparation de sa surface après l'avoir, si nécessaire, oxydée en surface ou munie d'un revêtement de même nature contenant de l'oxygène. Ce prétraitement est effectué dans les conditions indiquées ci-dessus.

Le prétraitement de la fibre en présence d'hydrogène est avantageusement effectué pendant 10 à 60 minutes.

Le gaz porteur neutre utilisé en mélange avec l'ammoniac est avantageusement de l'azote.

L'injection du mélange de gaz porteur neutre et d'ammoniac dans un rapport en volume de 20 à 60 est avantageusement effectuée pendant 10 à 60 minutes.

Le gaz diluant neutre pour le chlorure d'aluminium est avantageusement de l'hélium.

Le chlorure d'aluminium est avantageusement présent à raison d'environ 45 % en volume dans le gaz diluant neutre.

La durée de l'injection du chlorure d'aluminium dans un gaz diluant neutre est avantageusement de 5 à 20 minutes.

Le nitrure d'aluminium, AlN, est ensuite déposé à partir de ses précurseurs gazeux, à savoir le chlorure d'aluminium, AlCl₃ et l'ammoniac, NH₃.

La durée de l'étape de dépôt du revêtement d'AlN dépend, pour une enceinte donnée et des débits de gaz donnés, de l'épaisseur d'AlN à déposer. Cette épaisseur est en général de 0,1 à 1µm, et est de préférence de 0,2 à 1µm. Une épaisseur de dépôt d'environ 0,2µm est en général suffisante pour procurer à la fibre les propriétés requises. Si l'épaisseur du dépôt dépasse 1µm, il peut se produire des pontages entre les monofilaments constituant le toron de fibre, ce qui fragilise fortement le toron, rendant ainsi sa manipulation difficile.

Le gaz porteur neutre utilisé dans l'étape de dépôt du nitrure d'aluminium est avantageusement de l'azote.

Le courant de gaz neutre utilisé pour refroidir l'enceinte est avantageusement un courant d'azote.

Les fibres obtenues par le procédé selon l'invention peuvent être utilisées pour fabriquer des composites à renfort fibreux et à matrice verre, vitrocéramique ou céramique selon les procédés connus de fabrication de tels composites, notamment ceux qui sont décrits dans les références données ci-dessus.

Des exemples de procédés pouvant être avantageusement utilisés sont décrits dans les demandes de brevet FR 2 655 327 et FR 2 682 674, ainsi que dans l'article de P. Lespade et Coll., dans : SCIENCE AND TECHNOLOGY OF NEW GLASSES, Proceedings of the International Conference of Science and Technology of New Glasses, Tokyo, 1991, pages 147-152.

Les figures annexées représentent :

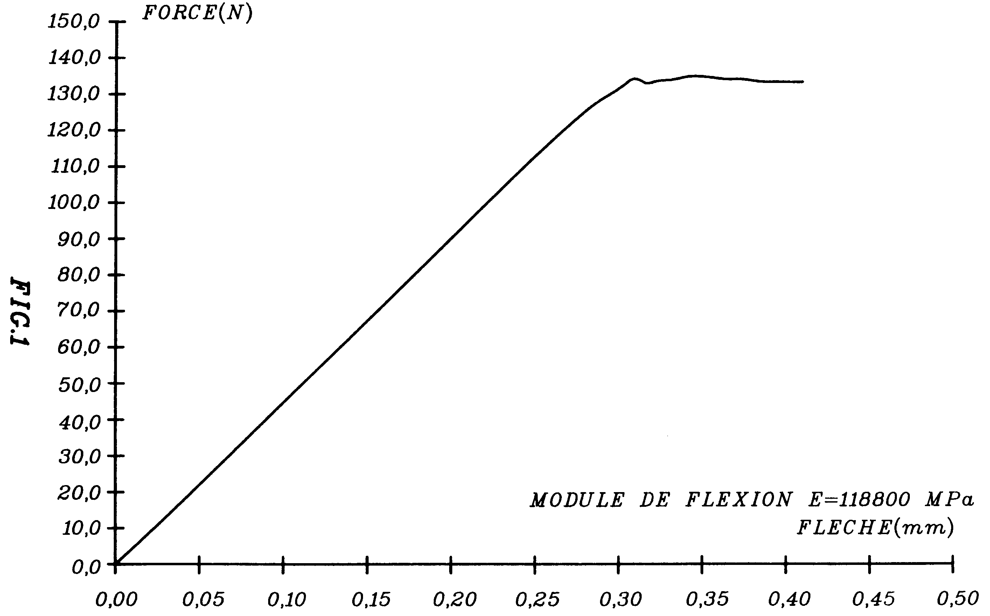

Figure 1 : le comportement (essai de flexion 3 points à la température ambiante, à l'air ; module de flexion E = 118 800 MPa) d'un composite obtenu comme décrit dans l'exemple qui suit, à partir d'une fibre de SiC Nicalon® revêtue d'une couche de AlN de 0,2µm d'épaisseur et comportant une matrice de MgO, Al₂O₃, SiO₂, Li₂O (MAS-L) ;

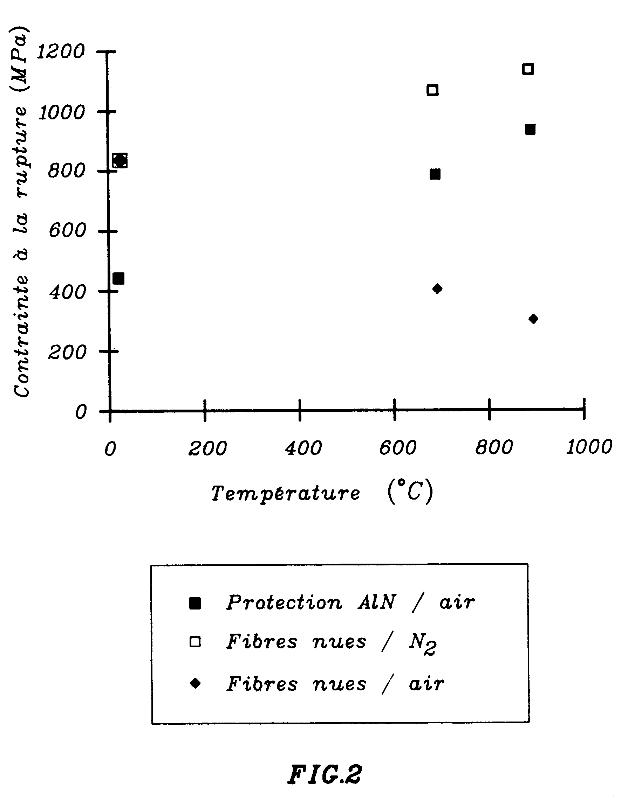

Figure 2 : l'évolution, en fonction de la température, de la contrainte à la rupture pour trois composites à matrice MAS-L comprenant, en tant que renfort fibreux, des fibres de SiC Nicalon®, dans les conditions respectives suivantes :
   - fibres munies d'un revêtement protecteur de AlN : essai réalisé à l'air ;
   - fibres nues : essai réalisé sous azote ; et
   - fibres nues : essai réalisé à l'air.

On constate qu'à l'air, avec des fibres revêtues de AlN, la contrainte à la rupture augmente avec la température pour se rapprocher de celle d'un composite à fibres nues sous azote, alors qu'à l'air, avec des fibres nues, la contrainte à la rupture décroît rapidement et de façon importante.

L'efficacité du revêtement de AlN pour améliorer la tenue à l'oxydation d'un matériau composite est ainsi clairement démontrée.

Le composite élaboré à partir de fibres de SiC non revêtues possède, à la température ambiante, une valeur élevée de la contrainte à la rupture ainsi qu'une déformation importante (environ 1 %). Un tel comportement provient de la formation, à l'interface fibre-matrice, d'une couche de carbone de quelques nanomètres d'épaisseur. Lorsqu'il est testé à des températures plus élevées, sous air, l'endommagement du composite expose cette couche de carbone qui s'oxyde. Le comportement du composite devient alors de type fragile.

Le composite élaboré avec des fibres revêtues de AlN possède un comportement non fragile sur toute la plage de température où il a été testé. Dans ce cas, le comportement non fragile résulte de la faible adhésion de l'AlN sur la fibre de SiC. Lorsque la température augmente, la contrainte à la rupture augmente car le frettage de la fibre par le revêtement et la matrice tend à diminuer, conférant ainsi au composite un comportement proche de celui, à la température ambiante, du matériau élaboré avec des fibres non revêtues.

L'invention est décrite plus en détail au moyen de l'exemple illustratif qui suit.

### EXEMPLE :

### Fabrication d'un matériau composite à matrice MgO-Al₂O₃-SiO₂-Li₂O(MAS-L) renforcée par de la fibre de carbure de silicium (SiC) revêtue d'un dépôt de nitrure d'aluminium (AlN).

### Traitement selon l'invention de la fibre

De la fibre de SiC fabriquée par la société NIPPON CARBON et commercialisée sous la dénomination NICALON® NLM 202, enroulée autour d'un outillage en graphite ajouré, est traitée dans une enceinte de dépôt chimique en phase vapeur (DCPV).

Cette enceinte est un four chauffé par induction. La zone de chauffage a un diamètre de 600 mm et une hauteur de 600 mm. Une sole en rotation fait tourner l'outillage supportant la fibre, ce qui permet d'améliorer l'homogénéité du traitement.

Le dépôt de AlN sur la fibre est réalisé en trois étapes :
- traitement thermique
- phase de transition
- dépôt proprement dit.

### Traitement thermique :

Après introduction de l'outillage supportant la fibre dans le four, la température de ce dernier est portée jusqu'à une valeur de 850 à 1200°C, sous un débit d'hydrogène de 1 à 7 l/min et une pression de 50 à 300 mbar. La température choisie est maintenue pendant 10 à 60 minutes (palier).

### Phase de transition :

Un mélange d'azote et d'ammoniac est ensuite introduit dans le four à un débit de 0,1 à 0,5 l/min pendant 10 à 60 minutes. L'injection du mélange de gaz est ensuite arrêtée et la pression interne du four est régulée à environ 2 mbar. Du chlorure d'aluminium à 45 % en volume dans de l'hélium est ensuite injecté pendant 5 à 20 minutes, à un débit de 0,1 à 1 l/min.

### Dépôt de AlN :

Le dépôt est réalisé par injection simultanée dans le four des deux mélanges gazeux suivants :
1er mélange :
   - AlCl₃ à un débit de 5 à 40 l/h et
   - N₂ à un débit de 1 à 10 l/min.
2ème mélange :
   - NH₃ à un débit de 0,01 à 0,1 l/min et
   - N₂ à un débit de 1 à 10 l/min.

La durée du dépôt peut varier de 30 minutes à plusieurs heures, selon l'épaisseur d'AlN désirée qui est de préférence comprise entre 0,1 et 1µm.

Quand l'épaisseur d'AlN désirée est obtenue, l'injection des mélanges gazeux est arrêtée et le four est refroidi sous courant d'azote.

La fibre ainsi revêtue est extraite du four et est déroulée puis est ensuite utilisée pour la fabrication du composite.

### Elaboration du composite

Le composite est fabriqué selon une technique connue, par exemple comme décrit dans les demandes de brevet FR 2 655 327 et FR 2 682 674 mais sans traitement d'élimination de l'ensimage.

La fibre est imprégnée par passage dans une barbotine constituée (en poids) de :

| | |
|---|---|
| - polyméthacrylate de méthyle (PMMA) | 5 % |
| - poudre de verre MAS-L | 35 % |
| - monochlorobenzène | 60 %. |

Elle est ensuite enroulée de façon jointive sur un mandrin multifaces. Après étuvage à 80°C, des nappes sont découpées aux dimensions du matériau composite à réaliser et introduites dans un moule de pressage, avec une orientation unidirectionnelle.

L'ensemble est soumis au traitement thermique de densification et de céramisation suivant :
- augmentation de la température sous vide (20 mbar) et avec une pression du piston de 4 MPa, jusqu'à 1025°C en 245 min, avec un premier palier de 30 min à 280°C après 60 min, un deuxième palier de 30 min à 550°C après 135 min et un troisième palier de 30 min à 830°C après 195 min,
- augmentation progressive de la température jusqu'à 1050°C, avec introduction d'azote, en 5 min,
- augmentation de la température sous atmosphère d'azote (1000 mbar) jusqu'à 1325°C en 55 min, puis jusqu'à 1340°C en 5 min, en augmentant la pression du piston jusqu'à 20 MPa,
- retour à la température de 1325°C en 8 min, sous la pression du piston de 20 MPa, et sous 1000 mbar d'azote,
- refroidissement progressif jusqu'à 1000°C, en 43 min, sous la pression du piston de 20 MPa, et sous 1000 mbar d'azote,
- relâchement total de la pression du piston en 5 minutes avec léger refroidissement du produit, en maintenant l'atmosphère d'azote.

Le composite obtenu après refroidissement complet présente un taux volumique de fibres de 40 % (Vf = 0,4). Les fibres sont alignées de façon unidirectionnelle.

## Revendications

1. Procédé de traitement d'une fibre de renfort de type céramique non-oxyde ou de carbone qui peut être utilisée dans la fabrication d'un matériau composite à matrice verre, vitrocéramique ou céramique présentant une bonne tenue à l'oxydation jusqu'à des températures voisines de 1200°C, pendant une durée prolongée, caractérisé en ce qu'il comprend essentiellement les étapes successives consistant à :
- si nécessaire, oxyder la fibre en surface ou y déposer une couche de même composition mais comprenant de l'oxygène ;
- introduire la fibre dans une enceinte de dépôt chimique en phase vapeur, dans un arrangement tel que les gaz puissent circuler librement dans l'enceinte ;
- effectuer un prétraitement de la fibre dans l'enceinte à une température choisie dans la gamme de 850 à 1250°C, en présence d'hydrogène, sous une pression de 50 à 300 mbar ;
- injecter dans l'enceinte un mélange de gaz porteur neutre et d'ammoniac dans un rapport en volume de 20 à 60 ;
- arrêter l'injection du mélange et régler la pression dans l'enceinte à une valeur de 1 à 10 mbar ;
- injecter dans l'enceinte du chlorure d'aluminium dans un gaz diluant neutre ;
- effectuer sur la fibre un dépôt de nitrure d'aluminium par injection simultanée dans l'enceinte d'un mélange constitué de chlorure d'aluminium et de gaz porteur neutre, dans un rapport en volume de 0,05 à 0,3, et d'un mélange constitué d'ammoniac et de gaz porteur neutre, dans un rapport en volume de 0,01 à 0,05, les deux mélanges étant utilisés dans un rapport en volume de 0,5 à 2, jusqu'à obtention de l'épaisseur de nitrure d'aluminium souhaitée ;
- stopper l'injection des mélanges gazeux ;
- refroidir l'enceinte sous un courant de gaz neutre ; et
- extraire les fibres ainsi traitées de l'enceinte.

2. Procédé selon la revendication 1, caractérisé en ce que la fibre est une fibre de SiC, de SiCN, de Si₃N₄ ou de carbone, de préférence une fibre de SiC ou de SiCN.

3. Procédé selon la revendication 1 ou 2, caractérisé en ce que le prétraitement de la fibre en présence d'hydrogène est effectué pendant 10 à 60 minutes.

4. Procédé selon l'une quelconque des revendications 1 à 3, caractérisé en ce que le gaz porteur neutre utilisé en mélange avec l'ammoniac est de l'azote.

5. Procédé selon l'une quelconque des revendications 1 à 4, caractérisé en ce que l'injection du mélange de gaz porteur neutre et d'ammoniac dans un rapport en volume de 20 à 60 est effectuée pendant 10 à 60 minutes.

6. Procédé selon l'une quelconque des revendications 1 à 5, caractérisé en ce que le gaz diluant neutre pour le chlorure d'aluminium est de l'hélium.

7. Procédé selon l'une quelconque des revendications 1 à 6, caractérisé en ce que le chlorure d'aluminium est présent à raison d'environ 45 % en volume dans le gaz diluant neutre.

8. Procédé selon l'une quelconque des revendications 1 à 7, caractérisé en ce que la durée de l'injection du chlorure d'aluminium dans un gaz diluant neutre est de 5 à 20 minutes.

9. Procédé selon l'une quelconque des revendications 1 à 8, caractérisé en ce que le dépôt de nitrure d'aluminium est poursuivi jusqu'à obtention d'une épaisseur de 0,1 à 1µm, de préférence de 0,2 à 1µm.

10. procédé selon la revendication 9, caractérisé en ce que le dépôt du nitrure d'aluminium est poursuivi jusqu'à obtention d'une épaisseur d'environ 0,2µm.

11. Procédé selon l'une quelconque des revendications 1 à 10, caractérisé en ce que le gaz porteur neutre utilisé dans l'étape de dépôt du nitrure d'aluminium est de l'azote.

12. Procédé selon l'une quelconque des revendications 1 à 11, caractérisé en ce que le courant de gaz neutre utilisé pour refroidir l'enceinte est un courant d'azote.

13. Utilisation de la fibre traitée par mise en oeuvre du procédé selon l'une quelconque des revendications 1 à 12 pour la fabrication d'un matériau composite à renfort fibreux et à matrice verre, vitrocéramique ou céramique.

14. Matériau composite à renfort fibreux et matrice verre, vitrocéramique ou céramique, caractérisé en ce que son renfort fibreux a subi, avant la fabrication du matériau composite, un prétraitement par mise en oeuvre du procédé selon l'une quelconque des revendications 1 à 12.

15. Matériau composite à renfort fibreux et matrice verre, vitrocéramique ou céramique, caractérisé en ce qu'il comprend essentiellement une matrice MgO-Al₂O₃-SiO₂-Li₂O (MAS-L) et un renfort en fibres de SiC revêtues, avant la fabrication du matériau composite, d'un dépôt de nitrure d'aluminium effectué par mise en oeuvre du procédé selon l'une quelconque des revendications 1 à 12.

## Claims

1. A process for treating a non-oxide ceramic or a carbon reinforcing fibre, which can be used in the manufacture of a composite material having a glass, glass-ceramic or ceramic matrix exhibiting good oxidative stability up to temperatures in the vicinity of 1200°C, for a prolonged period, characterized in that it essentially comprises the successive steps consisting of:
- if necessary, oxidizing the fibre superficially or depositing thereon a layer of the same composition but including oxygen;
- placing the fibre in a chemical vapor deposition vessel, in an arrangement such that the gases can circulate freely within the vessel;
- carrying out a pre-treatment of the fibre in the vessel at a temperature selected in the 850 to 1250°C range, in the presence of hydrogen, at a pressure of 50 to 300 mbar;
- injecting into the vessel a mixture of neutral carrier gas and ammonia in a volume ratio of 20 to 60;
- stopping injection of the mixture and setting the pressure inside the vessel to a value of 1 to 10 mbar;
- injecting into the vessel aluminium chloride in a neutral diluting gas;
- producing a deposit of aluminium nitride on the fibre by simultaneously injecting into the vessel a mixture composed of aluminium chloride and neutral carrier gas, in a volume ratio of 0.05 to 0.3, and a mixture composed of ammonia and neutral carrier gas, in a volume ratio of 0.01 to 0.05, the two mixtures being used in a volume ratio of 0.5 to 2, until the desired thickness of aluminium nitride is obtained;
- stopping the injection of the gaseous mixtures;
- cooling the vessel with a stream of neutral gas; and
- extracting the fibres thus treated from the vessel.

2. A process according to claim 1, characterized in that the fibre is an SiC, SiCN, Si₃N₄ or carbon fibre, preferably an SiC or SiCN fibre.

3. A process according to claim 1 or 2, characterized in that the pre-treatment of the fibre in the presence of hydrogen is carried out for 10 to 60 minutes.

4. A process according to any one of claims 1 to 3, characterized in that the neutral carrier gas used in a mixture with ammonia is nitrogen.

5. A process according to any one of claims 1 to 4, characterized in that the injection of the mixture of neutral carrier gas and of ammonia in a volume ratio of 20 to 60 is carried out for 10 to 60 minutes.

6. A process according to any one of claims 1 to 5, characterized in that the neutral diluting gas for aluminium chloride is helium.

7. A process according to any one of claims 1 to 6, characterized in that aluminium chloride is present in a proportion of about 45 % by volume in the neutral diluting gas.

8. A process according to any one of claims 1 to 7, characterized in that the time for which aluminium chloride in a neutral diluting gas is injected is 5 to 20 minutes.

9. A process according to any one of claims 1 to 8, characterized in that aluminium nitride is deposited until a thickness of 0.1 to 1µm, preferably of 0.2 to 1µm is obtained.

10. A process according to claim 9, characterized in that aluminium nitride is deposited until a thickness of about 0.2µm is obtained.

11. A process according to any one of claims 1 to 10, characterized in that the neutral carrier gas used in the aluminium nitride deposition step is nitrogen.

12. A process according to any one of claims 1 to 11, characterized in that the stream of neutral gas used to cool the vessel is a stream of nitrogen.

13. Use of the fibre treated by implementing the process according to any one of claims 1 to 12 for the manufacture of a composite material with a fibrous reinforcement and a glass, glass-ceramic or ceramic matrix.

14. A composite material with a fibrous reinforcement and a glass, glass-ceramic or ceramic matrix, characterized in that its fibrous reinforcement has undergone, prior to the manufacture of the composite material, a pre-treatment through implementation of the process according to any one of claims 1 to 12.

15. A composite material with a fibrous reinforcement and a glass, glass-ceramic or ceramic matrix, characterized in that it essentially comprises an MgO-Al₂O₃-SiO₂-Li₂O (MAS-L) matrix and a reinforcement of SiC fibres coated, prior to the manufacture of the composite material, with a deposit of aluminium nitride obtained by implementing the process according to any one of claims 1 to 12.

## Patentansprüche

1. Verfahren zur Behandlung einer Verstärkungsfaser vom nicht-oxidischen keramischen Typ oder aus Kohlenstoff, die bei der Herstellung eines Verbundwerkstoffes mit Glas-, Glaskeramik- oder Keramikmatrix verwendet werden kann, der eine gute Oxidationsbeständigkeit bis zu Temperaturen in der Nähe von 1.200°C während einer langen Zeitspanne zeigt, dadurch gekennzeichnet, daß es im wesentlichen die aufeinanderfolgenden Schritte umfaßt, die daraus bestehen:
- die Faser, wenn notwendig, an der Oberfläche zu oxidieren oder dort eine Schicht mit der gleichen Zusammensetzung aufzubringen, die jedoch Sauerstoff beinhaltet;
- die Faser in einen Behälter für eine chemische Gasphasenabscheidung in einer solchen Anordnung einzubringen, daß die Gase frei in dem Behälter zirkulieren können:
- eine Vorbehandlung der Faser in dem Behälter bei einer Temperatur, die im Bereich von 850°C bis 1.250°C gewählt ist, in Anwesenheit von Wasserstoff unter einem Druck von 50 mbar bis 300 mbar auszuführen;
- ein Gemisch aus einem neutralen Trägergas und Ammoniak in einem Volumenverhältnis von 20 bis 60 in den Behälter zu injizieren;
- die Injektion des Gemisches zu stoppen und den Druck in dem Behälter auf einen Wert von 1 mbar bis 10 mbar einzuregeln;
- Aluminiumchlorid in einem neutralen Verdünnungsgas in den Behälter zu injizieren;
- durch gleichzeitige Injektion eines Gemisches, das aus Aluminiumchlorid und einem neutralen Trägergas in einem Volumenverhältnis von 0,05 bis 0,3 besteht, und eines Gemisches, das aus Ammoniak und einem neutralen Trägergas in einem Volumenverhältnis von 0,01 bis 0,05 besteht, in den Behälter eine Abscheidung aus Aluminiumnitrid auf der Faser auszuführen, bis die gewünschte Dicke des Aluminiumnitrids erreicht ist, wobei die zwei Gemische in einem Volumenverhältnis von 0,5 bis 2 verwendet werden;
- die Injektion der Gasgemische zu stoppen:
- den Behälter unter einem Neutralgasstrom abzukühlen; und
- die auf diese Weise behandelten Fasern aus dein Behälter zu entnehmen.

2. Verfahren nach Anspruch 1, dadurch gekennzeichnet, daß die Faser eine Faser aus SiC, SiCN, Si₃N₄ oder aus Kohlenstoff ist vorzugsweise eine Faser aus SiC oder SiCN.

3. Verfahren nach Anspruch 1 oder 2, dadurch gekennzeichnet, daß die Vorbehandlung der Faser in Anwesenheit von Wasserstoff während 10 Minuten bis 60 Minuten ausgeführt wird.

4. Verfahren nach einen, der Ansprüche 1 bis 3, dadurch gekennzeichnet, daß das in Mischung mit Ammoniak verwendete neutrale Trägergas Stickstoff ist.

5. Verfahren nach einem der Ansprüche 1 bis 4, dadurch gekennzeichnet, daß die Injektion des Gemisches aus neutralem Trägergas und Ammoniak in einem Volumenverhältnis von 20 bis 60 während 10 Minuten bis 60 Minuten ausgeführt wird.

6. Verfahren nach einem der Ansprüche 1 bis 5, dadurch gekennzeichnet, daß das neutrale Verdünnungsgas für das Aluminiumchlorid Helium ist.

7. Verfahren nach einem der Ansprüche 1 bis 6, dadurch gekennzeichnet, daß das Aluminiumchlorid im Verhältnis von ungefähr 45 Volumenprozent in dem neutralen Verdünnungsgas vorliegt.

8. Verfahren nach einem der Ansprüche 1 bis 7, dadurch gekennzeichnet, daß die Dauer der Injektion des Aluminiumchlorids in ein neutrales Verdünnungsgas 5 Minuten bis 20 Minuten beträgt.

9. Verfahren nach einem der Ansprüche 1 bis 8, dadurch gekennzeichnet, daß die Abscheidung aus Aluminiumnitrid bis zur Erzielung einer Dicke von 0,1µm bis 1µm, vorzugsweise von 0,2µm bis 1µm, fortgesetzt wird.

10. Verfahren nach Anspruch 9, dadurch gekennzeichnet, daß die Abscheidung des Aluminiumnitrids bis zur Erzielung einer Dicke von ungefähr 0,2µm fortgesetzt wird.

11. Verfahren nach einem der Ansprüche 1 bis 10, dadurch gekennzeichnet, daß das in dem Schritt der Abscheidung des Aluminiumnitrids verwendete neutrale Trägergas Stickstoff ist.

12. Verfahren nach einem der Ansprüche 1 bis 11, dadurch gekennzeichnet, daß der zum Abkühlen des Behälters verwendete neutrale Gasstrom ein Stickstoffstrom ist.

13. Verwendung der durch Ausführen des Verfahrens gemäß einem der Ansprüche 1 bis 12 behandelten Faser zur Herstellung eines Verbundwerkstoffes mit Faserverstärkung und Glas-, Glaskeramik oder Keramikmatrix.

14. Verbundwerkstoff mit Faserverstärkung und Glas-, Glaskeramik- oder Keramikmatrix, dadurch gekennzeichnet, daß seine Faserverstärkung vor der Herstellung des Verbundwerkstoffes durch Ausführen des Verfahrens gemäß einein der Ansprüche 1 bis 12 einer Vorbehandlung unterzogen wurde.

15. Verbundwerkstoff mit Faserverstärkung und Glas-, Glaskeramik- oder Keramikmatrix, dadurch gekennzeichnet, daß er im wesentlichen eine MgO-Al₂O₃-SiO₂-Li₂O(MAS-L)-Matrix und eine Verstärkung aus SiC-Fasern beinhaltet, die vor der Herstellung des Verbundwerkstoffes mit einer Abscheidung aus Aluminiumnitrid überzogen wurden, die durch Ausführen des Verfahrens gemäß einem der Ansprüche 1 bis 12 bewirkt wurde.
